# EUROPEAN PATENT APPLICATION

(11) **EP 3 779 391 A1**
(43) Date of publication of application: **17.02.2021**
(21) Application number: 19191794.7
(22) Date of filing: 14.08.2019
(51) Int. Cl.: G01L 19/14, B81B 7/00

(54) **SENSOR ARRANGEMENT AND METHOD FOR FABRICATING A SENSOR ARRANGEMENT**

(71) Applicant: Sciosense B.V., 5656 AE Eindhoven (NL)
(72) Inventor: Besling, Willem Frederik Adrianus, 8640 Rapperswil (CH); Singulani, Anderson, 8640 Rapperswil (CH); Tak, Coenraad Cornelis, 8640 Rapperswil (CH); van der Avoort, Casper, 8640 Rapperswil (CH)
(74) Representative: Epping - Hermann - Fischer

(57) **Abstract**

A sensor arrangement (10) comprises a sensor die (11), an interposer (12) and a support (13). The sensor die (11) comprises a contact area (14), a suspended area (15) and a sensitive element (16) located in the suspended area (15). The interposer (12) comprises at least two vias (48, 49) connecting a first side (46) of the interposer (12) to a second side (47) of the interposer (12). The support (13) mechanically and electrically connects the contact area (14) of the sensor die (11) to the first side (46) of the interposer (12) and comprises at least two contact joints (30 to 35).

## Description

The present disclosure is related to a sensor arrangement, an apparatus comprising the sensor arrangement and a method for fabricating a sensor arrangement.

A sensor arrangement comprises a sensor die with a sensitive element. The sensitive element may comprise a mechanical element such as a membrane, diaphragm, cantilever or beam. The mechanical element is a mechanically sensitive part. The sensor die is typically attached to another body. The process of attaching the other body to the sensor die or temperature changes during operation of the sensor arrangement may have a mechanical influence on the sensitive element of the sensor die.

It is an object to provide a sensor arrangement, an apparatus comprising the sensor arrangement and a method for fabricating a sensor arrangement that improves the stress decoupling inside the sensor arrangement.

The objects are achieved by the subject-matter of the independent claims. Further developments and embodiments are described in the dependent claims.

In an embodiment, a sensor arrangement comprises a sensor die, an interposer and a support. The sensor die comprises a contact area, a suspended area and a sensitive element located in the suspended area. The interposer comprises at least two vias connecting a first side of the interposer to a second side of the interposer. The support mechanically and electrically connects the contact area of the sensor die to the first side of the interposer and comprises at least two contact joints.

Advantageously, since only the contact area of the sensor die is coupled to the interposer via the support, a mechanical stress in the suspended area is kept low. The suspended area is only connected by the contact area and the support to another body, namely to the interposer.

In an embodiment, the at least two contact joints electrically connect connection lines of the sensor die to the at least two vias of the interposer, e.g. directly or by conducting lines of the interposer.

In an embodiment, the support comprises a bar oriented parallel to an imaginary line through the at least two contact joints. The bar connects the contact area of the sensor die to the first side of the interposer. Thus, the bar is located in between the contact joints and the suspended area. The suspended area may be realized as membrane area. The membrane area is an area which may include at least the sensitive element, wherein the sensitive element may comprise a membrane. Advantageously, the bar functions as support, reduces stress in the suspended area and avoids that an underfill can reach the membrane area.

In an embodiment, the support comprises a guard ring that surrounds the at least two contact pads and connects the contact area of the sensor die to the first side of the interposer. The guard ring may include the bar and further parts such as e.g. further bars. The guard ring may have a rectangular shape in a top view. The bar and the guard ring may be free of an electrical signal. The bar and the guard ring may not be designed for signal transmission or power transmission. Advantageously, the guard ring prevents humidity or dust from reaching the at least two contact joints.

In an embodiment, the sensitive element comprises a membrane which is rectangular and has a main membrane direction. Thus, the sensitive element may be configured for pressure sensing.

In an embodiment, the main membrane direction is parallel to an imaginary line through the at least two contact joints. Advantageously, a mechanical stress of said membrane is kept lower in comparison to a membrane having a perpendicular orientation of the main membrane direction to the imaginary line.

In an embodiment, the sensor die comprises a first and a second edge which are parallel to each other. The first edge is adjacent to the contact area and the second edge is adjacent to the suspended area. The first and the second edge may be parallel to the main membrane direction. Advantageously, a distance of the first edge to the second edge can be minimized using this main membrane direction.

In an embodiment, the sensor die comprises a further sensitive element located in the suspended area. The further sensitive element comprises a further membrane. The further membrane is rectangular. A main membrane direction of the further membrane is parallel to the main membrane direction of the membrane. The further sensitive element may be configured for pressure sensing or as a reference element.

In an embodiment, at least one of the sensor die and the interposer comprises a CMOS integrated circuit, abbreviated CMOS IC. Advantageously, a signal of the sensitive element and a signal of the further sensitive element - if this element is present - can be evaluated by the CMOS IC.

In an embodiment, the sensor die comprises the CMOS IC. The CMOS IC is connected to the sensitive element. Thus, the pressure membrane or pressure membranes are integrated on top of the CMOS read-out circuit. In this example, the sensor die also comprises the transducer elements and the interposer is only for stress decoupling purposes. The CMOS IC may be connected to the further sensitive element, if this element is present. The CMOS circuit may be connected to the at least two contact joints. Advantageously, small signal changes provided by the sensitive element can be detected by the on-chip signal evaluation.

In an embodiment, the interposer is realized as one of a group comprising an interconnecting carrier, an interconnecting board and an interconnecting substrate. The interposer has a first and a second side which are parallel to each other. The first side of the interposer has a smaller distance to the sensor die in comparison to the second side of the interposer. The first side of the interposer faces the first side of the sensor die. The second side of the interposer may face e.g. a printed circuit board (abbreviated PCB), e.g. an end-customer PCB. The second side of the interposer may be oriented down with interposer bond pads (e.g. realized as solder pads) facing the end-customer PCB and the contact joints of the interposer are oriented upwards and facing the bond pads of the sensor die with the stress sensitive MEMS element or elements. Advantageously, contact joints on the first side of the interposer are not necessarily located directly above interposer bond pads, solder balls or other contacts on the second side of the interposer.

In an embodiment, the interposer is realized as one of a group comprising a silicon die, a printed circuit board, a polymer based laminate and a ceramic carrier. The silicon die may include an interconnect on one or both sides connected by through silicon vias, shorted TSVs. The printed circuit board, shorted PCB, may be a single layered or multi layered printed circuit board with vias. The ceramic carrier may include interconnect routing on one or both sides connected by vias. The polymer based laminate includes interconnect routing on one or both sides being connected by vias.

In an embodiment, the at least two contact joints are fabricated by metal diffusion bonding or eutectic bonding. Advantageously, the sensor die is fixed to the interposer by a wafer-to-wafer bonding process.

In an embodiment, the at least two contact joints comprise a material out of a group comprising Cu, Au, Al and Ti or a material combination out of a group comprising AuIn, CuSn, AuSn, AuGe, AuSi and AlGe. The material combinations are alloys. The alloys could also be written as AuₓIn_{y}, CuₓSn_{y}, AuₓSn_{y}, AuₓGe_{y}, AuₓSi_{y} and/or AlₓGe_{y}. Advantageously, at least one material or alloy is compatible with a CMOS technology.

In an embodiment, the sensitive element is one of a group comprising a pressure sensor element, an accelerometer element, a gyroscope element, an ultrasound transducer, a microphone, a speaker, a micro hot plate, an IR radiation detector and a bolometer. The bolometer may be an example of an IR radiation detector. The further sensitive element may also be one of this group or a reference element. The sensitive element and the further sensitive element may be the same element or different elements of this group.

In an embodiment, the sensor arrangement is fabricated using a chip scale package manufacturing technology (shorted CSP method). The CSP method can be applied for the fabrication of capacitive pressure sensors on a CMOS circuit and also for the fabrication of other sensors that are stress sensitive and may be solder-mounted on an end-customer PCB using underfill. These sensors or sensor elements are listed above.

In an embodiment, the interposer comprises at least two interposer bond pads and/or conducting lines on the second side of the interposer and are coupled to the at least two vias of the interposer. The interposer bond pad may be realized as solder ball or solder pad. Advantageously, the at least two interposer bond pads and/or conducting lines are electrically connected to the sensor die by the vias and embedded interconnect of the interposer and the support layer i.e. the electroconductive material between the further bond pads on the first side of the interposer and the bond pads of the sensor die. The sensor arrangement may include an underfill to make the sensor arrangement water tight. The interposer bond pads may e.g. be covered, surrounded and/or encapsulated with underfill material.

In an embodiment, the at least two interposer bond pads and/or conducting lines are operable to contact a PCB. Thus, the interposer bond pads are located to provide connections to contacts of the PCB.

In an embodiment, the sensor arrangement comprises an electrically isolating spacer arranged between the first side of the interposer and the first side of the sensor die. The electrically isolating spacer may couple the suspended area of the sensor die to the first side of the interposer. Advantageously, a tilt of the sensor die with respect to the interposer is avoided.

In an embodiment, an apparatus comprises the sensor arrangement. The apparatus is realized as one of a mobile device, a wearable, a vehicle and an air conditioner.

In an embodiment, a method for fabricating a sensor arrangement comprises
- providing a sensor die that comprises a contact area, a suspended area and a sensitive element located in the suspended area,
- providing an interposer that comprises a conductive layer and at least two vias connecting a first side of the interposer to a second side of the interposer, and
- connecting the sensor die to the interposer by a support which mechanically and electrically connects the contact area of the sensor die to the first side of the interposer and comprises at least two contact joints.

Advantageously, the contact area and the suspended area are separated resulting in a low mechanical stress of the sensitive element.

The method for fabricating a sensor arrangement may be implemented e.g. by fabricating the sensor arrangement according to one of the embodiments defined above.

In an embodiment, the connecting of the sensor die to the interposer is realized by bonding. Thus, the support is fabricated by bonding. The bonding may be realized as wafer-to-wafer bonding, shorted WTW bonding. The bonding may be e.g. wafer diffusion bonding or eutectic bonding.

In an embodiment, the at least two contact joints are fabricated by metal diffusion bonding or eutectic bonding. Advantageously, a stable mechanical connection between the sensor die and the interposer is realized.

In an embodiment, the sensor arrangement realizes a watertight chip scale package (shorted CSP) for a CMOS integrated capacitive pressure sensor using a diving board-on-interposer stress decoupling. Advantageously, the CSP may be watertight i.e. can be operated under water without electrical shorts. The sensor die is configured as a diving board.

In an embodiment, the contact area is placed on one side of the sensor die which reduces the mechanical stress in the suspended area. The contact area and the suspended area are laterally arranged to each other on the first side of the sensor die. The actual number of contact points (connections) is minimum two (e.g. electrical connection for capacitive or piezo resistive sensor read-out) but may comprise more electrical contact points (e.g. six) and in addition mechanical support contact points or lines and/or a guard ring around the electrical contact points to block and prevent water ingress and shortage of the electrical contact points. The contact joints are the electrical and mechanical interfaces from the sensor die to the interposer. The interposer bond pads included by the interposer are lying on the other side of the contact joints and are the interface to the PCB of the end-user.

In an embodiment, the sensor arrangement uses a design and a manufacturing method of a stress decoupled, water tight CSP for a monolithically integrated capacitive pressure sensor on a CMOS circuit. The stress decoupling is achieved using a so-called diving board suspension of the sensor die that contains the pressure sensitive membranes and is fabricated as a CMOS die. The diving board is connected on one side to a multifunctional interposer that may be a silicon interposer. The function of the interposer may include
- to support for the diving board allowing to seal the electrical contacts from water and use underfill without impacting stress decoupling performance,
- to provide a redistribution layer to avoid tombstone effect during soldering,
- membrane protection during handling pick and place and/or
- mechanical and thermal stress decoupling from the PCB.

The sensor arrangement may be realized by WTW bonding and may provide a solution for water tight contacts. The sensor arrangement may apply a predetermined orientation of the membranes with respect to the location of the contact joints which can be named fixed joints or contact pads.

Typically, a CSP is inherently sensitive to stress due to the fact that it is soldered directly to a PCB. Moreover, the aim of chip scale packaging is too make the CSP thin which will make it more prone the mechanical deformation e.g. during test and calibration or due to board bending. The diving board stress decoupling approach explained in this disclosure gives in combination with the rectangular membrane geometry a good stress decoupling performance from thermal induced stress point of view. Especially during soldering the stress state could change drastically due to the large CTE (coefficient of thermal expansion) mismatch of the silicon die with respect to the PCB material. Advantageously, the sensor arrangement can be fabricated at low cost and with a low manufacturing complexity.

In an embodiment, a solder mounting of a pressure sensitive element or a CMOS integrated pressure sensor die on a PCB by flip chip technique without an interposer may have several disadvantages. Not only the stress decoupling performance may be not achievable but also solder reflux could come into contact with the pressure sensitive membranes during soldering of the CSP to the PCB. In addition, underfill may not be used to protect the solder contacts against corrosion or submersion into water. Advantageously, the sensor arrangement avoids electrical shorts under humid or condensing conditions or even during submersion into water. This is accomplished by a guard ring (which may be named shield ring) around the electrical contacts at diving board level and using underfill during solder mounting of the interposer to the PCB.

In an embodiment, the CSP comprises a supporting carrier and a substrate with a strain sensitive element or several strain sensitive elements in which these parts are connected on one side to create a free-hanging suspended area with a diving board construction. An element can be named transducer.

In an embodiment, the support of the diving board is located on one side of the die and could also function as electrical feedthrough for the electrical signals.

In an embodiment, the support for the diving board is configured as a guard ring around the electrical contacts to protect the electrical feedthroughs from shorts.

In an embodiment, the suspended section comprises the strain sensitive elements.

In an embodiment, the strain sensitive elements comprise pressure sensitive membranes.

In an embodiment, the pressure sensitive membranes are integrated directly on CMOS passivation layer.

In an embodiment, the strain sensitive element is a capacitive pressure sensor.

In an embodiment, the strain sensitive element(s) has/have a rectangular shape and are oriented in the direction of the support layer providing electrical contacts on one side of the die.

In an embodiment, the carrier and substrate are bonded together using a wafer-to-wafer bonding technique.

In an embodiment, the wafer-to-wafer bonding technique comprises Al/Ge eutectic bonding.

In an embodiment, the carrier comprises a silicon interposer with through silicon vias (abbreviated TSV) and single or dual distribution layers on one or on either side.

In an embodiment, the carrier comprises a ceramic and polymeric material with two metal layer interconnect.

In an embodiment, the carrier can comprise a CMOS read-out die. In this case, the substrate with the pressure sensitive membranes only contains the MEMS elements.

In an embodiment, the diving board thickness is typically thicker (e.g. 400 µm) than the carrier (e.g. 100 µm)

In an embodiment, contact points on top of the sensor die are predefined with a patterning technique to reduce stress on the strain sensitive elements.

Advantageously, the diving board stress decoupling approach uses a silicon interposer and WTW bonding. A water tight CSP solution is achieved with a eutectic seal ring for an integrated capacitive pressure sensor on a CMOS circuit.

Advantageously, the sensor arrangement realizes a chip scale package solution for a pressure sensor providing:
- A small form factor can be achieved (footprint as well as package height).
- The pressure sensitive membranes are monolithically integrated on top of the read-out circuit which avoids external wire bonds that could create shorts or pickup noise.
- A good stress decoupling is achieved due to the diving board principle.
- The strain which is imposed via the solder ball connections to the pressure sensor is not affecting the membrane deflection due to the orientation of the membranes with respect to the solder ball array.
- The support bar or the seal ring around the electrical contacts allow to reduce the stress in the direction perpendicular to the primary orientation of the membranes during mechanical loading and thermal stressing.

The CSP will reduce overall assembly costs. In current Land Grid Array assembled pressure sensors, the assembly and packaging costs may take up e.g. 50% of the manufacturing costs. Land Grid Array can be abbreviated as LGA. A CSP solution may allow reduction of assembly costs with e.g. 40-50%. Water tight packaged pressure sensors are sold at much higher price levels than non-watertight versions. The CSP solution of the sensor arrangement allows a small form factor i.e. down from 3mm · 3mm · 3mm to 1mm · 1mm · 0.7mm, much lower (e.g. 10 times) power consumption due to capacitive read-out, a significantly reduced pressure noise (e.g. 5 times), a high output data rate (e.g. 10 times) to allow movement tracking, and improved relative and absolute accuracies due to the good stress decoupling properties. The sensor arrangement can be used e.g. for wearable and mobile applications.

The following description of figures of embodiments may further illustrate and explain aspects of the sensor arrangement and the method for fabricating a sensor arrangement. Devices and circuit parts with the same structure and the same effect, respectively, appear with equivalent reference symbols. In so far as devices or circuit parts correspond to one another in terms of their function in different figures, the description thereof is not repeated for each of the following figures.
Figures 1, 2A, 2B, 3A, 3B, 4A, 4B, 5A and 5B show examples of a sensor arrangement;
Figures 6A and 6B show examples of characteristics of a sensor die;
Figures 7A and 7B show examples of a sensor arrangement;
Figures 8A to 8C show examples of a sensor arrangement and their characteristics;
Figures 9A and 9B show examples of materials used for the fabrication of a sensor arrangement; and
Figure 10 shows an example of fabrication steps of a sensor arrangement.

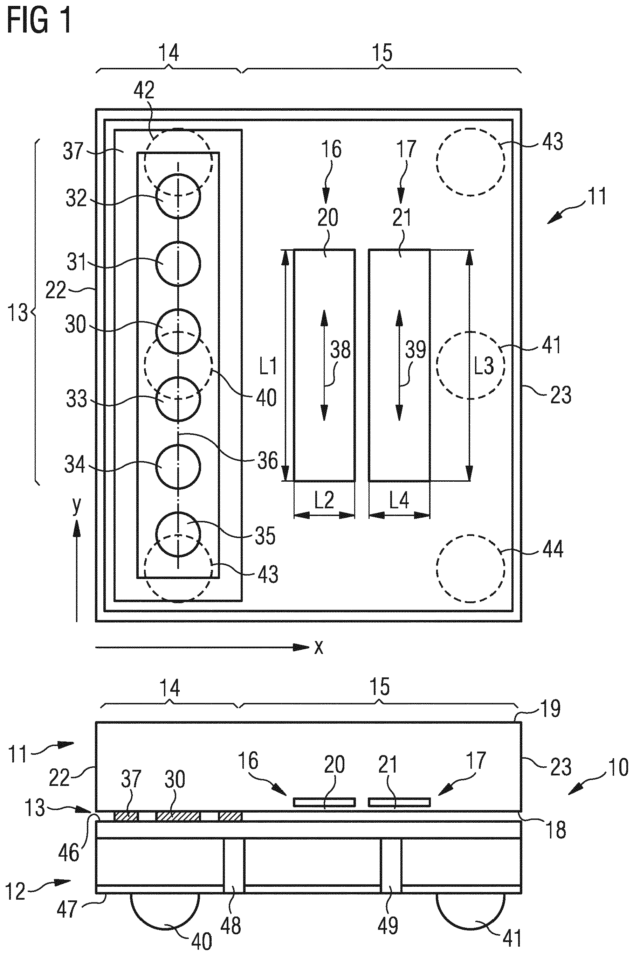

Figure 1 shows an example of a sensor arrangement 10. The lower part of Figure 1 shows a cross-section of the sensor arrangement 10. The sensor arrangement 10 comprises a sensor die 11, an interposer 12 and a support 13. The support 13 is arranged between the sensor die 11 and the interposer 12. The sensor die 11 is coupled via the support 13 to the interposer 12. The sensor die 11 comprises a contact area 14 and a suspended area 15. A sensitive element 16 of the sensor die 11 is arranged in the suspended area 15. Moreover, a further sensitive element 17 of the sensor die 11 may be also arranged in the suspended area 15. The sensor die 11 has a first and a second side 18, 19. The sensitive element 16 and the further sensitive element 17 are located on the first side 18 of the sensor die 11. The first side 18 of the sensor die 11 comprises the contact area 14 and the suspended area 15. The first side 18 only consists of one contact area 14 and one suspended area 15. The contact area 14 has the form of one rectangle. The suspended area 15 has the form of one rectangle.

The first side 18 of the sensor die 11 is opposite to the interposer 12. The first side 18 of the sensor die 11 is connected via the support 13 to the interposer 12. The second side 19 of the sensor die 11 is free from any contact, i.e. free from any mechanical or electrical contact to another body. Thus, the sensor die 11 is exclusively connected to another body (that is the interposer 12) via the support 13.

The upper part of Figure 1 shows a view onto the support 13 and the first side 18 of the sensor die 11. The sensitive element 16 comprises a membrane 20. The membrane 20 is rectangular. Similarly, the further sensitive element 17 comprises a further membrane 21. The further membrane 21 is rectangular. A main membrane direction 38 of the membrane 20 is parallel to a main membrane direction 39 of the further membrane 21. The membrane 20 has a first and a second side length L1, L2. The first side length L1 is measured in the main membrane direction 38. The first and the second side length L1, L2 may have the following relationships:
L1 > L2 or L1 > 2 . L2 or L1 > 3 . L2

The further membrane 21 has a third and a fourth side length L3, L4. The first and the third side length L1, L3 may have an identical value. The second and the fourth side length L2, L4 may have the same value. The sensor die 11 has a first and a second edge 22, 23 that are parallel to each other. The first edge 22 is adjacent to the contact area 14. The second edge 23 is adjacent to the suspended area 15. The first and the second edge 22, 23 are parallel to the main membrane direction 38 of the membrane 20.

The support 13 comprises a first and a second contact joint 30, 31. The support 13 comprises a first number N of contact joints 30 to 35. Thus, in the example shown in Figure 1, the first number N is 6. However, the first number N may also be 2, 3, 4, 5 and larger than 6. The first number N may be at least 2, at least 3 or at least 4. The first number N of contact joints 30 to 35 are arranged on an imaginary line 36. The imaginary line 36 is parallel to the main membrane direction 38 of the membrane 20 and to the main membrane direction 39 of the further membrane 21. The first and the second edge 22, 23 are parallel to the imaginary line 36. An x-direction is directed from the first edge 22 to the second edge 23. A y-direction is perpendicular to the x-direction and is parallel to the first and the second edge 22, 23, to the imaginary line 36 and to the main membrane directions 38, 39 of the membrane 20 and of the further membrane 21. The contact joints 30 to 35 may be realized as electrical contact points, bond pads, contact pads, electrical connections, fixed joints, contact volumes and/or electrical feedthroughs.

The support 13 comprises a guard ring 37 that surrounds the first and the second contact joint 30, 32. Thus, the guard ring 37 surrounds the first number N of contact joints 30 to 35. The guard ring 37 and the first number N of contact joints 30 to 35 are realized by the same material or the same materials, for example by the same metal or the same metals. The guard ring 37 and the first number N of contact joints 30 to 35 are realized by the same metal layer or the same metal layers. In the cross section, the first contact joint 30 is between two bars of the guard ring 37.

The interposer 12 comprises a first and a second interposer bond pad 40, 40 (as shown in the lower part and indicated by broken lines in the upper part of Figure 1). The interposer bond pads 40, 41 may be realized as solder balls or solder bumps. The interposer 12 comprises a second number M of interposer bond pads 40 to 45. The second number M may be 2, 3, 4, 5, 6 or more than 6. The second number M may be at least 2, at least 3 or at least 4. The interposer 12 comprises a first and a second side 46, 47. The second number M of interposer bond pads 40 to 45 are arranged on the second side 47, e.g. at edges of the second side 47 of the interposer 12. The second number M of interposer bond pads 40 to 45 are arranged in a regular manner, e.g. in an array.

The first side 46 of the interposer 12 is opposite to the first side 18 of the sensor die 11. There is a gap between the suspended area 15 and the first side 46 of the interposer 12. The interposer 12 comprises a first and a second via 48, 49 (as illustrated in the cross-section shown in Figure 1). The interposer 12 may comprise a third number L of vias 48, 49. The third number L may be 2, 3, 4, 5, 6 or more than 6. The third number L may be at least 2, at least 3 or at least 4. The third number L of vias 48, 49 connect the first side 46 to the second side 47 of the interposer 12. More specifically, the third number L of vias 48, 49 electrically connect the contact joints 30 to 35 or conduction lines arranged at the first side 46 to interposer bond pads 40 to 45, conduction lines or bond pads arranged at the second side 47 of the interposer 12. Thus, at least some of the third number L of vias 48, 49 are connected to several or each of the first number N of contact joints 30 to 35 on one side. Moreover, at least some of the third number L of vias 48, 49 are connected to several or each of the second number M of interposer bond pads 40 to 45. In an option, there may be at least one contact joint and/or at least one via and/or at least one interposer bond pad having e.g. only a mechanical function and no electrical function.

In an example, the first number N of contact joints 30 to 35 may be identical with the third number L of vias 48, 49. The third number L of vias 48, 49 may be identical with the second number M of interposer bond pads 40 to 45.

Advantageously, the sensor arrangement 10 is realized as a chip scale package, shorted CSP, with interposer and diving board construction for the pressure sensitive elements 16, 17 and guard ring 37 around the electrical contacts 30 to 35 to avoid electrical shorts during water immersion.

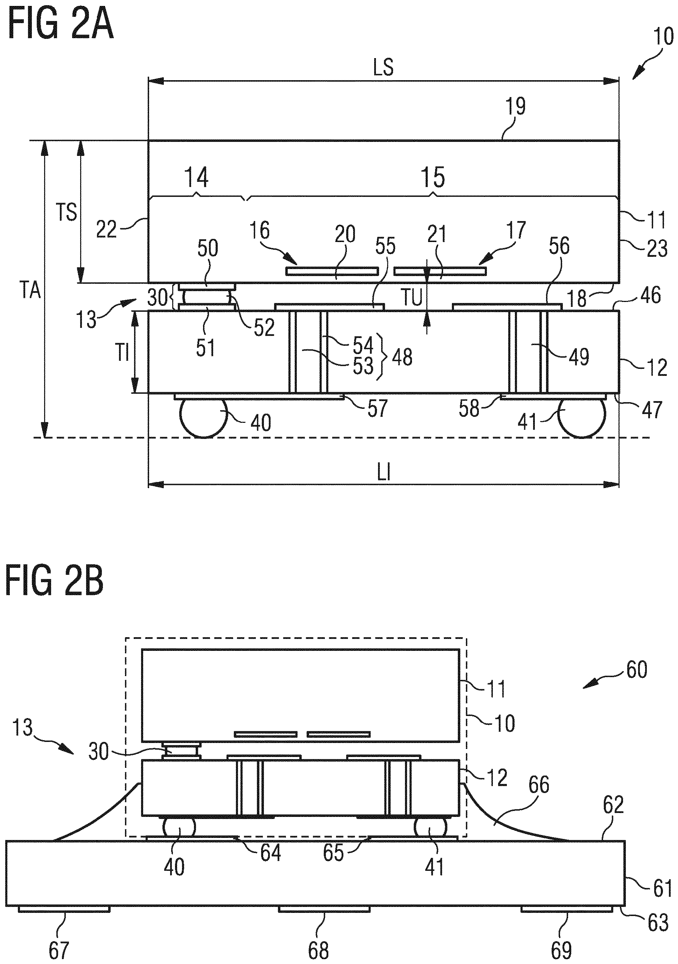

Advantageously, the sensor arrangement 10 applies to the design of a water tight CSP for a capacitive pressure sensor integrated on a CMOS read-out circuit. The sensor arrangement 10 is related to reduce stress related issues associated to mechanical loading during test and calibration phase as well as thermal induced stress after soldering the sensor arrangement 10 to a PCB 61 (as shown in Figure 2B). The diving board construction gives good stress decoupling properties in the direction perpendicular to the support 13. The support 13 of the sensor die 11 comprises electrical feedthroughs by the contact joints 30 to 35. The sensor die 11 is implemented as diving board.

Advantageously, stress decoupling is independent of the thickness of the PCB 61 of a customer; use of underfill is possible; thermal properties of the PCB 61 are predetermined and may match with the thermal properties of the interposer 12. Advantageously, a large membrane 20, 21 with respect to the total area of the sensor die 11 does not impact the fragility nor the stress decoupling properties. Advantageously, process control issue may be mitigated. Advantageously, front end process development is possible.

Simulations show a stress decoupling during mechanical deformation e.g. during test and calibration stage: 1 N force applied in the center of top package lid does not deform the CMOS die more than 10 µm downwards: yield strength of Al is not exceeded. Furthermore, stress decoupling is realized during thermal induced stress by soldering i.e. during cooling of device from 220°C to room temperature. Maximum stress tensor in x direction is 0.017 MN/m² in the membrane layer.

Advantageously, the mounting here is strongly asymmetric, whereas regular interposer mounting is symmetric. The support 13 is located asymmetric at the sensor die 11. The support 13 is also located asymmetric at the interposer 12. The interposer 12 is implemented as an interconnecting carrier, an interconnecting board and/or an interconnecting substrate. Thus, the interposer bond pads 40 to 45 are not on a line, but are distributed at the second side 47 of the interposer 12, e.g. at all four borders. The first number N of contact joints 30 to 35 are arranged on a line on the first side 46 of the interposer 12. Thus, the interposer bond pads 40 to 45 are not directly "under" the first number N of contact joints 30 to 35. The electrical connections from the interposer bond pads 40 to 45 to the contact joints 30 to 35 are achieved by the conducting lines 55 to 58 and the vias 48, 49. Thus, the interposer 12 gives a high flexibility for placement of the interposer bond pads 40 to 45.

Figure 2A shows an example of the sensor arrangement 10 which is a further development of the sensor arrangement shown in Figure 1. The sensor die 11 is realized as a complementary metal oxide semiconductor die, abbreviated as CMOS die. The sensor die 11 comprises integrated pressure membranes. The membrane 20 is implemented as integrated pressure membrane. The further membrane 21 is also implemented as integrated pressure membrane. The support 13 is free of the guard ring 37. The sensor die 11 obtains a first edge length LS. The first edge length LS is the distance between the first edge 22 and the second edge 23. The interposer 12 obtains a second edge length LI. On the cross section, the first and the second edge lengths LS, LI have the same value or approximately the same value. Also the edge lengths of the sensor die 11 and of the interposer 12 perpendicular to the cross-section shown in Figure 2A may be equal or approximately equal.

The first contact joint 30 is realized by a bond pad 50 on the sensor die 11, by a further bond pad 51 on the interposer 12 and by a solder joint 52. The solder joint 52 is between the bond pad 50 of the sensor die 11 and the further bond pad 51 of the interposer 12. The other contact joints 31 to 35 may be realized such as the first contact joint 30. Alternatively, the solder joint 52 may be replaced e.g. by a eutectic bond, as explained below.

The first via 48 comprises a metal plug 53 and an isolating layer 54. The isolating layer 54 encloses side walls of the metal plug 53 and thus isolates the metal plug 53 from other parts of the interposer 12. The other vias 49 may be realized such as the first via 48. The interposer 12 may be made of silicon. The third number L of vias 48, 49 are fabricated as integrated through-silicon vias, abbreviated as integrated TSV. The interposer 12 comprises a first conducting line 55 arranged on the first side 46 of the interposer 12 and conductively connected to the first via 48. Optionally, the first conducting line 55 may be connected to the first contact joint 30. Moreover, the interposer 12 comprises a second conducting line 56 arranged on the first side 46 of the interposer 12 and conductively connected to the second via 49 and optionally also to the second contact joint 31.

Moreover, the interposer 12 comprises a further first conducting line 57 which is located on the second side 47 of the interposer 12 and connects the first via 48 to the first interposer bond pad 40. Thus, the first conducting line 56 is connected by the first via 48 and the further first conducting line 57 to the first interposer bond pad 40. Similarly, the interposer 12 comprises a further second conducting line 58 which is located on the second side 47 of the interposer 12 and connects the second via 49 to the second interposer bond pad 41.

The sensor die 11 has a thickness TS and the interposer 12 has a thickness TI. The sensor arrangement 10 has a thickness TA, wherein TA ≥ TS + TI. The support 13 may have a thickness TU. The thickness TU is the distance of the first side 18 of the sensor die 11 to the first side 46 of the interposer 12. Thus, TA = TS + TI + TU or TA ≈ TS + TI + TU

The interposer 12 may be free from a circuit. Thus, the sensor die 11 comprises an integrated circuit (shorted IC) realized by CMOS technology. Thus, the sensor die 11 comprises a CMOS IC. The first number N of contact joints 30 to 35 are electrically connected to the CMOS IC. The IC performs signal evaluation of sensor signals provided by the sensitive element 16 and the further sensitive element 17.

Alternatively, there may be contact joints of the first number N of contact joints 30 to 35 which are not electrically connected to the CMOS IC. However, at least two or at least three of the contact joints 30 to 35 are connected to the CMOS IC.

In an alternative, not shown embodiment, the support 13 comprises the guard ring 37 as shown in Figure 1.

Figure 2B shows an example of an arrangement 60 with the sensor arrangement 10 that is a further development of the examples shown in Figures 1 and 2A. The arrangement 60 additionally comprises a printed circuit broad 61 (shorted PCB) which is connected to the sensor arrangement 10. The second side 47 of the interposer 12 is connected to a first side 62 the PCB 61. Thus, the second number M of interposer bond pads 40 to 45 are coupling the interposer 12 to the PCB 61. The PCB 61 comprises a first and a second conducting line 64, 65 at the first side 62. The interposer 12 is connected via the interposer bond pads 40 to 45 to the first and the second connecting line 64, 65 of the PCB 61. The PCB 61 may comprise further conducting lines 67 to 69 at a second side 63. The PCB 61 may have conducting lines 63, 64, 67 to 69 on both sides 62, 63.

The arrangement 60 comprises an underfill 66 which fills a gap between the interposer 12 and the PCB 61. The underfill 66 is also arranged at parts of side edges of the interposer 12. For example the underfill 66 may cover about half of the side surfaces of the interposer 12.

In Figure 2B, the CSP is illustrated with diving board 11 and silicon interposer 12 mounted on the PCB 61 with underfill 66. In this example, wafer-to-wafer bonding (shorted WTW bonding) is performed using solder bumps or solder joints 52 on the bond pads 50, 51. The interposer 12 may comprise silicon with redistribution layers on both sides 46, 47 connected by through silicon vias 48, 49 (shorted TSV), as shown in Figure 2A. Advantageously, a diving board stress decoupling method is used in combination with the interposer 12. The interposer 12 can be soldered and/or mounted to the PCB 61 of a customer with underfill 66 to protect the electrical connections 30 to 35 for electrical shorts when exposed to water.

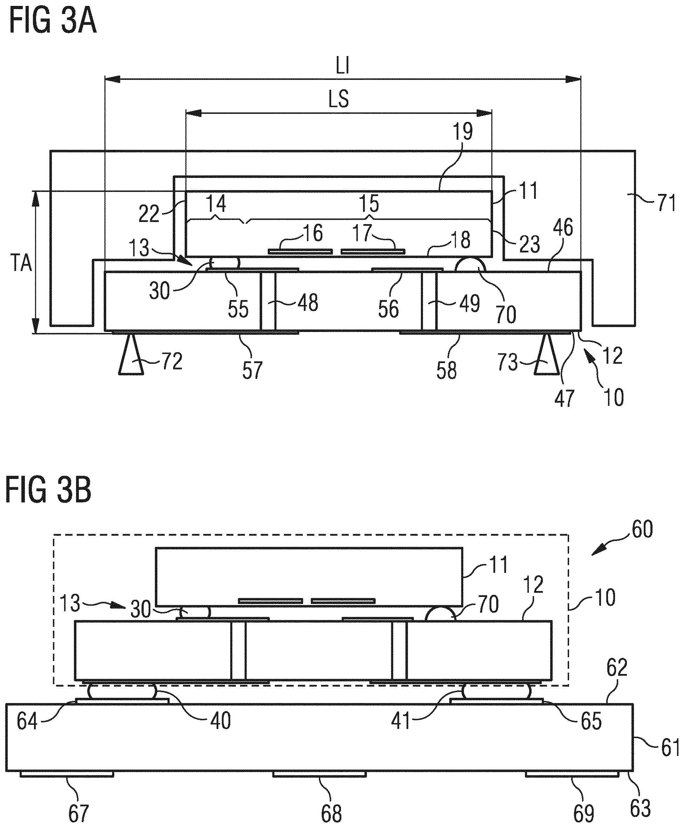

Figure 3A shows a further example of the sensor arrangement 10 which is a further development of the examples shown in Figures 1, 2A and 2B. The second edge length LI has a larger value in comparison to the first edge length LS. In a cross section perpendicular to the cross-section shown in Figure 3A, the edge length of the sensor die 11 may be equal, approximately equal, smaller or larger than the edge length of the interposer 12. The sensor arrangement 10 comprises an electrically isolating spacer 70 located between the sensor die 11 and the interposer 12. The electrically isolating spacer 70 is located between the suspended area 15 and the first side 46 of the interposer 12. The electrically isolating spacer 70 is located near the second edge 23 of the sensor die 11. The electrically isolating spacer 70 is free of a contact to the membrane 20 and the further membrane 21.

As shown in Figure 3A, a mechanical tool 71 is realized such that it can exert a force to the interposer 12 without exerting a force on the sensor die 11. In case the mechanical tool 71 is in contact with the interposer 12, the sensor die 11 is inside a cavity of the mechanical tool 71 and is not mechanically contacted by the mechanical tool 71. Thus, the second side 53 of the interposer 12 can be contacted, for example, by pins or needles 72, 73. The mechanical tool 71 presses the interposer 12 to the pins or needles 72, 73. Advantageously, an electrical measurement, for example for test or calibration purposes, can be performed without exerting any contact and thus without exerting any force or stress to the sensor die 11.

Figure 3B shows a further example of the arrangement 60 comprising the sensor arrangement 10 and the PCB 61 which is a further development of the above shown examples. The arrangement 60 may be free of an underfill 66. The interposer 12 may comprise a two metal layered polymer based laminate comprising of e.g. FR4 material or a ceramic carrier. The advantage of this approach is that the interposer 12 can be made larger than the sensor die 11. The interposer 12 may be named carrier. This will allow to mitigate the mechanical imposed stress during calibration. In this particular case the layout of the slot for each individual package is designed in such way that the force of the test pins (i.e. pogo pins) is transferred via the carrier to the metal supporting base without making physical contact or pushing on the sensor die 11. The sensor die 11 is a flip-chipped CMOS die. A small disadvantage may be that each individual sensor die 11 is individually picked, placed and mounted on the interposer 12.

Patterned resist or patterned photo resist (such as e.g. patterned SU8) on the sensor die 11 or on the interposer 12 or silicone dispensed droplets on the interposer 12 or on the sensor die 11 could be used as electrically isolating spacer 70. The spacer 70 realizes a mechanical support on one side and thus avoids that the sensor die 11 will tilt (the so-called tombstone effect). The sensor arrangement 10 realizes a device construction with the interposer 12 as a supporting carrier for the flip-chipped sensor die 11.

As shown in Figure 3B, the CSP comprises the diving board 11 and the two metal layered ceramic or polymeric carrier 12 flip chip mounted on the PCB 61. The electrically isolating spacer 70 is dispensed on the opposite side of the contact joints 30 to 35 to avoid tilt. The electrically isolating spacer 70 is realized e.g. as a silicone spacer droplet.

In an alternative, not shown embodiment, the underfill 66 fills the gap between the PCB 61 and the interposer 12 and may also cover parts of side surfaces of the interposer 12.

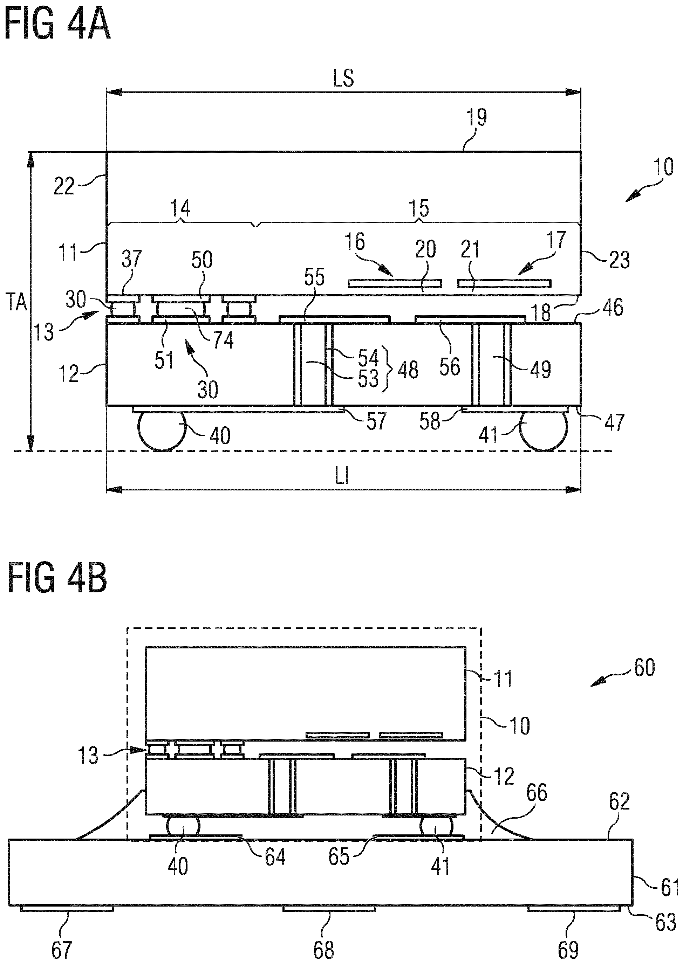

Figure 4A shows a further example of the sensor arrangement 10 which is a further development of the above-shown examples. The sensor die 11 is fabricated as a CMOS die with integrated pressure membranes 20, 21. The interposer 12 is implemented as a silicon interposer. The third number L of vias 54, 55 are realized as through-silicon vias, abbreviated as TSV. The first edge length LS of the sensor die 11 is equal or approximately equal to the first edge length LI of the interposer 12. Also the edge lengths of the sensor die 11 and of the interposer 12 perpendicular to the cross-section shown in Figure 4A may be equal or approximately equal.

The sensor arrangement 10 may be realized by a WTW bonding technique. The sensor arrangement 10 is realized by a sawing process of a WTW stack. Thus, the edge lengths of the sensor die 11 are equal to the edge lengths of the interposer 12, e.g. in a top or a bottom view. The sensor die 11 and the interposer 12 are arranged on each other without a lateral misalignment or a lateral lag.

Thus, the first contact joint 30 comprises the bond pad 50 or another metal layer on the first side 18 of the sensor die 11, the further bond pad 51 or another metal layer on the first side 46 of the interposer 12 and a eutectic bonding material 74 between the bond pads 50, 51, respectively between the metal layers. The guard ring 37 is realized by the same structure as the first number N of contact joints 30 to 35.

Figure 4B shows a further example of the arrangement 60 which is a further development of the above-shown examples. In Figure 4B, a watertight CSP is illustrated with a eutectically mounted pressure sensor die 11 in diving board configuration onto a silicon interposer 12 with TSV's all solder mounted on the PCB 61 with underfill 66.

The advantage of using silicon is that WTW bonding techniques can be used to attach the interposer 12 to the pressure sensor die 11. This saves assembly costs as not every sensor die 11 has to be individually picked, placed and mounted onto the carrier 12. In addition, the tombstoning effect is avoided as two wafers are bonded together before singulation. Moreover, the coefficient of thermal expansion, shorted CTE, of the Si interposer 12 and the CMOS pressure sensor die 11 is identical which reduces thermal induced stress effects. Also a fully water immersible package can be created using the guard ring 37 around the contact joints 30 to 35 and the underfill 66 underneath the interposer 12. The WTW bonding may advantageously be carried out using eutectic bonding.

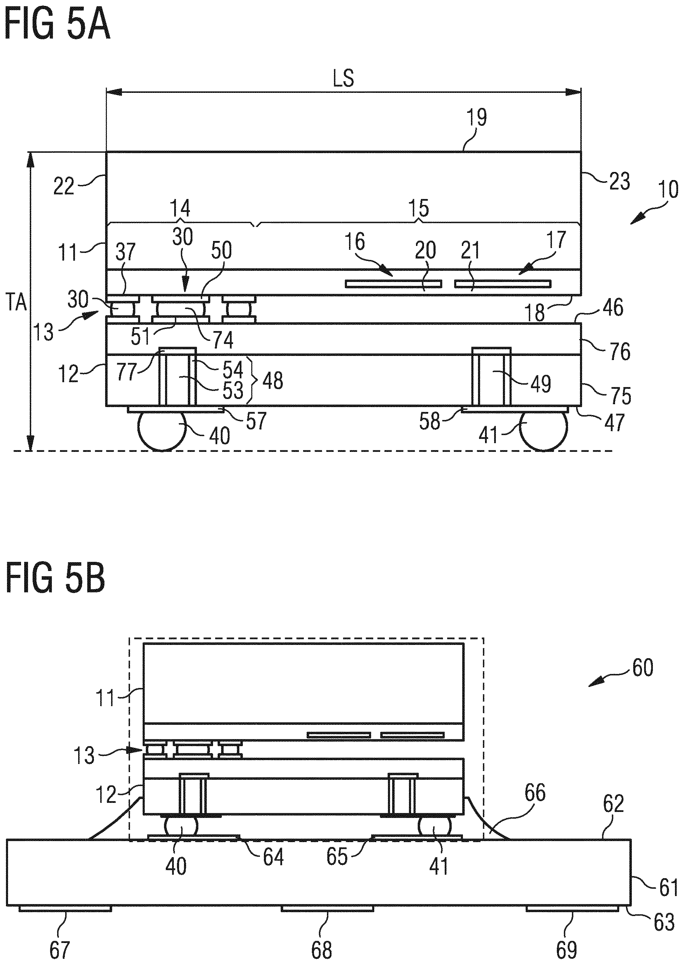

Figure 5A shows a further example of the sensor arrangement 10 which is a further development of the above-shown examples. The interposer 12 is realized as an IC. The IC may be realized on the first side 46 of the interposer 12. The interposer 12 is fabricated using a CMOS technology. The interposer 12 comprises a readout IC, for example a readout application-specific integrated circuit, abbreviated as ASIC. The interposer 12 is realized as an ASIC die. The interposer 12 comprises an interposer substrate 75 and an interposer metallization stack 76. The interposer substrate 75 may be a semiconductor substrate, such as e.g. a silicon substrate.

The interposer metallization stack 76 and the interposer substrate 75 form the IC. The interposer metallization stack 76 has a smaller distance to the first side 46 of the interposer 12 with respect to the second side 47 of the interposer 12. The third number L of vias 54, 55 connect conducting lines realized by a first metallization layer 77 of the interposer metallization stack 76. The conducting lines of the first metallization layer 77 are coupled by the third number L of vias to conducting lines on the second side 47 of the interposer 12 and thus to the second number M of interposer bond pads 40 to 45. The sensor arrangement 10 may be fabricated using eutectic bonding. The sensor die 11 may be free of an IC.

Alternatively, the sensor die 11 comprises an IC. Some of the functions for evaluating the sensor signal or signals are realized by the IC of the sensor die 11 and other functions for evaluating are realized by the IC of the interposer 12.

Figure 5B shows a further example of the arrangement 60 which is a further development of the above-shown examples. The sensor die 11 is realized as pressure sensor die, pressure sensor MEMS die, MEMS die, pressure sensitive MEMS element, MEMS pressure transducer and/or capacitive pressure transducer. Micro-electro-mechanical system is abbreviated as MEMS. The interposer 12 is implemented as a CMOS read-out ASIC. In Figure 5B, a watertight CSP includes a eutectically mounted sensor die 11 in diving board configuration onto the interposer 12 with TSV's all solder mounted on the PCB 61 with underfill 66.

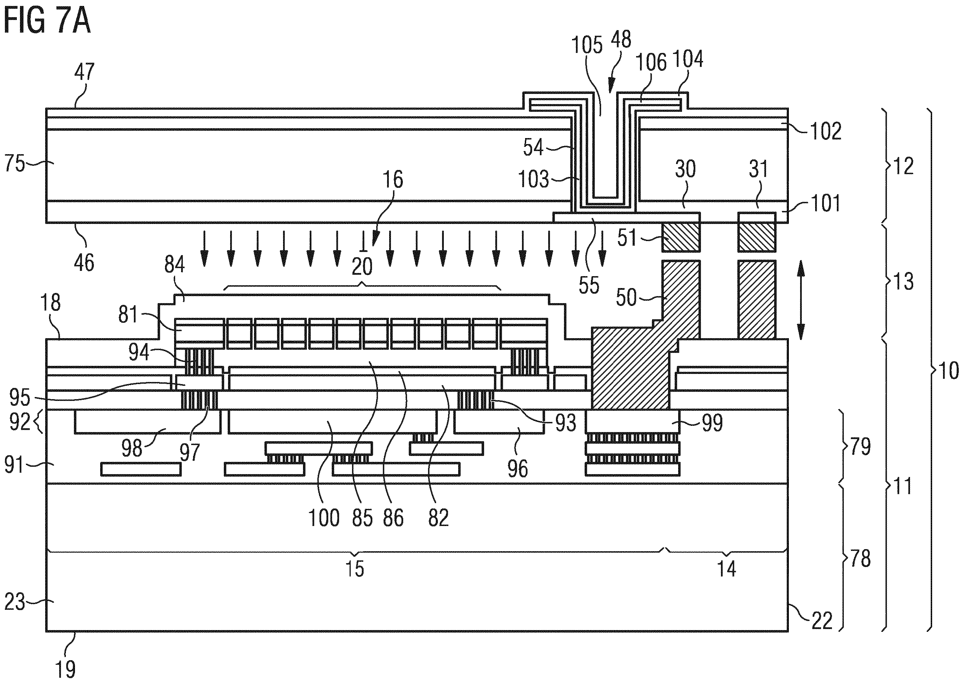

In an embodiment, the interposer 12 is configured as CMOS read-out circuit and the sensor die 11 is free of an IC. The sensor die 11 is attached on top of the interposer 12. The electrical feedthroughs 30 to 35 are now used to connect the top electrode and the bottom electrode (as shown in Figure 7A) of the sensor die 11 to the read-out circuit realized by the interposer 12. The advantage is that the CMOS manufacturing and the MEMS manufacturing can be carried out independently from each other. The MEMS wafer or the MEMS dies can be tested before the WTW bonding phase.

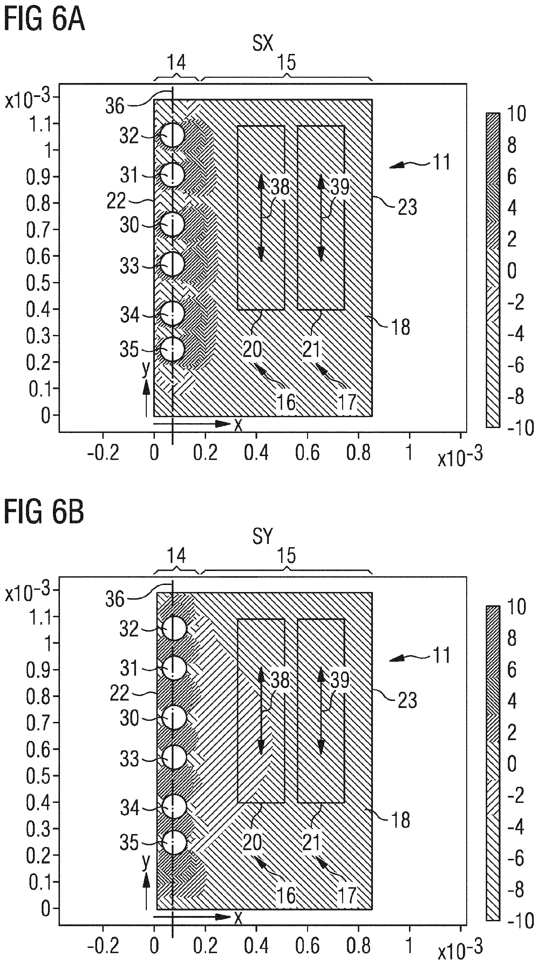

Figures 6A and 6B show an example of a characteristic of the sensor die 12. In Figure 6A, a stress SX of the sensor die 11 in the x-direction and in Figure 6B a stress SY of the sensor die 11 in the y-direction are shown. In Figures 6A and 6B, the stress tensor at the surface is indicated. The stress SX, SY is measured in MN/m². Positive values indicate a tensile stress and negative values indicate a compressive stress. The highest stress levels are near the contact joints 30 to 35. The stress SX is nearly zero in the membrane 20 and the further membrane 21. Moreover, the stress SY is zero or very small in the membrane 20 and the further membrane 21. Thus, by using the suspended area 15, stress SX, SY in the membrane 20 and in the further membrane 21 is kept very low and the stress SX, SY is concentrated in the contact area 14.

The second side length L2 may be named width of the membrane 20. The second side length L2 may have a value out of a range 165 µm to 185 µm or alternatively out of a range 100 µm to 300 µm. Typically, L2 may be 175 µm. The first side length L1 may be named length of the membrane 20. The first side length L1 may have a value out of a range 500 µm to 1000 µm or alternatively out of a range 310 µm to 2000 µm. Typically, L1 may be 700 µm. The first length L1 may be i.e. the length of the sensor die 11 minus edge exclusion of 100 µm to 200 µm. Therefore, an accuracy of a measurement performed by the sensor element 16 and the further sensor element 17 is increased.

The sensor arrangement 10 is based on a CSP solution for stress decoupling by a diving board approach. The pressure sensitive elements 16, 17 are located in the diving board section 15. The suspension of the diving board 11 is on one side of the diving board 11 and comprises electrical connections 30 to 35 to the bottom part of the CSP called supporting substrate or interposer 12. The electrical connection of the pressure sensor die 11 with or without integrated electronic readout occurs via solder connections or via eutectic bonding. The electrical connections 30 to 35 are located on one side of the sensor die 11 to create a freely suspended part 15 that encompasses the pressure sensitive membranes 20, 21.

In an embodiment, the pressure sensitive membranes 20, 21 are directly integrated on top of a CMOS read-out chip (see Figure 7A). The membranes 20, 21 may have a rectangular shape. In an embodiment, two membranes 20, 21 are used which are rectangular. The contact joints 30 to 35 may be oriented in the direction of the long side of the rectangular membranes 20, 21. This is advantageous from stress decoupling perspective: the main axis in which solder stress is working is in the longitudinal direction of the membranes 20, 21. The stress sensitivity is in this direction the lowest. Due to the diving board construction the stress in the direction perpendicular to the main membrane directions 38, 39 i.e. in the direction of the smallest side of the rectangles the stress will be the lowest. As the membrane deflection is mainly influenced by stress variation in perpendicular direction it is important to have an as small as possible stress change in this direction (see Figures 6A and 6B).

In Figures 6A and 6B, average mechanical stress evaluated at the substrate interface due to soldering of the CSP to the PCB 61 is shown. In Figure 6A, the stress is evaluated in x-direction (i.e. horizontal in this picture and perpendicular to the long side of the rectangular membrane 20) at the location of the membrane 20. The average stress is < 0.006 MN/m² for a 400 µm thick sensor die 11 and a 100 µm thick interposer 12 (stress is 0.017 MN/m² for TS = TI = 200 pm, so thickness can be scaled without impact). The sensor die 11 is a CMOS die. According to Figure 6B, the stress SY (i.e. vertical in this picture and aligned with the long side of the rectangular membrane 20) is much larger due to thermal induced distortions between the solder joints. The stress SX is much lower due to the fact that the sensor die 11 is hanging in free space and not pulling in x-direction. As the rectangular membranes 20, 21 are more prone to membrane stress in x-direction, a diving board construction is especially beneficial for rectangular membrane(s) when the diving board support 13 is oriented in the same longitudinal direction as the rectangular membranes 20, 21.

Figure 7A shows details of the sensor arrangement 10 which is a further development of the above-shown examples. The sensor die 11 is realized as a semiconductor body that may be a CMOS semiconductor body. The sensitive element 16 comprises a top and a bottom electrode 81, 82. The top electrode 81 may be implemented as a top metal electrode. The top electrode 81 may comprise tungsten. The top electrode 81 may be realized as a metal layer stack comprising at least two layers. For example the metal layer stack comprises or consist of three or five metal layers. The middle layer of the metal layer stack is made of tungsten. For example, the metal layer stack is fabricated as a Ti/TiN/W/Ti/TiN layer stack. The symbol / indicates a layer stack. The bottom electrode 82 may be implemented as a bottom metal electrode. The sensitive element 16 comprises the membrane 20. The membrane 20 comprises the top electrode 81. Moreover, the membrane 20 comprises a dielectric layer 84. The dielectric layer 84 may be arranged on top of the top electrode 81. The dielectric layer 84 may be fabricated as a passivation sealing layer.

The sensitive element 16 comprises a cavity 85. The cavity 85 is between the top electrode 81 and the bottom electrode 82. The top electrode 81 is between the cavity 85 and the dielectric layer 84. The sensitive element 16 may comprise a further dielectric layer 86. The further dielectric layer 86 may be realized as an etch stop layer. The further dielectric layer 86 is arranged between the bottom electrode 82 and the cavity 85. The cavity 85 is fabricated by etching of a sacrificial layer (not shown in Figure 7A). The sacrificial layer is etched through holes in the top electrode 81. After removal of the sacrificial layer, the holes are closed by the dielectric layer 84. An area of the membrane 20 is defined by a first via 94. The first via 94 encircles the cavity 85.

The sensor die 11 comprises a sensor substrate 78 and a metallization stack 79. The metallization stack 79 comprises a first dielectric layer 91 and a first metallization layer 92 and may e.g. comprise further metallization layers and further dielectric layers not shown in Figure 7A. A part 96 of the first metallization layer 92 is connected by a via 93 to the bottom electrode 82. The top electrode 81 is connected by the first via 94 to a metal layer 95. The metal layer 95 is connected by a second via 97 to a further part 98 of the first metallization layer 92. An additional part 100 of the first metallization layer 92 is located near the bottom electrode 82 and is realized as a shielding layer.

The parts 96, 98 of the first metallization layer 92 are connected to the IC. The IC is realized as a complementary metal-oxide-semiconductor circuit, shorted as CMOS circuit. The IC is realized by the sensor substrate 78 and the metallization stack 79. The bond pad 50 of the sensor die 11 is connected to a further part 99 of the first metallization layer 92.

The interposer 12 is realized out of an interposer wafer. The interposer 12 comprises a first dielectric layer 101 at the first side 46 and a second dielectric layer 102 at the second side 47. The further bond pad 51 of the interposer 12 is on the first dielectric layer 101. The first via 48 comprises the isolating layer 54, a conducting via layer 103 and a isolating via layer 104. The isolating via layer 104 isolates the conducting via layer 103 from an opening 105 of the first via 48. The first conducting line 55 of the interposer 12 connects the further bond pad 51 of the interposer 12 to the conducting via layer 103 of the first via 48. A further conducting via layer 106 is deposited on the conducting via layer 103. The further vias 49 may be realized such as the first via 48.

The bond pad 50 of the sensor die 11 comprises aluminum. The bond pad 50 may be made of aluminum or of a compound of aluminum and other materials such as copper and silicon. The bond pad 50 for the sensor die 11 and the further bond pad 51 of the interposer 12 are designed for the realization of a eutectic bond. The aluminum layer of the bond pad 50 has a thickness between 5 µm and 10 µm or between 2 µm and 20 µm. The eutectic bond may be fabricated as an Al/Ge eutectic bond. The further bond pad 51 of the interposer 12 may be made of germanium or of a compound of germanium and other materials. The first conducting line 55 of the interposer 12 may be made of aluminum or of a compound of aluminum and other materials such as copper and silicon. The further contact joints 31 to 35 may be realized such as the first contact joint 30.

The further sensitive element 17 may be realized such as the sensitive element 16. The sensor arrangement 10 is designed as a pressure sensor e.g. for a mobile, mobile phone or mobile communication device and uses capacitive technology. The bond pad 50 of the sensor die 11 is configured e.g. for providing a digitized pressure signal. The sensor arrangement 10 obtains low power and high accuracy. For capacitive read-out, bond wires between ASIC die and MEMS die are not desirable (produce noise). The sensor die 11 is fabricated by monolithic integration of MEMS structures and ASIC. The tungsten membrane technology allows to manufacture the pressure sensitive membrane 20 on top of the first dielectric layer 91 that may be a passivation layer. This brings as advantage a pressure transducer with read-out circuitry integrated in one single sensor die 11. In Figure 7A, WTW bonding is realized using Al/Ge eutectic bonding at elevated temperatures.

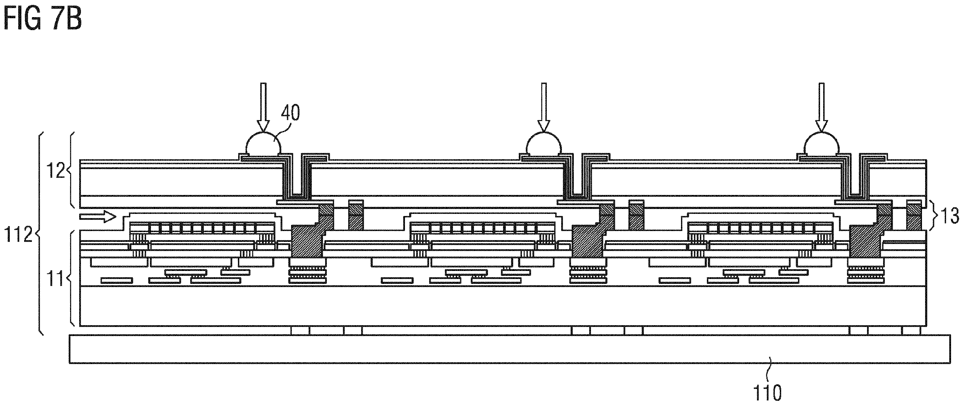

The interposer 12 on which the sensor die 11 is mounted may comprises through-silicon-vias 48, 49 (TSV's) and redistribution layers on the first and the second side 46, 47 of the interposer 12. The advantage of using an interposer 12 with TSV's 48, 49 is that the sensor arrangement 10 and especially the interposer 12 can be soldered and underfilled without impact on the stress decoupling performance. In an embodiment, the wafer on which the pressure sensitive membranes 20, 21 are located is bonded to the interposer wafer by eutectic bonding (see Figures 7A and 7B). Tungsten membranes 20, 21 are manufactured by monolithically integrating on top of a read-out ASIC. The tungsten membrane 20, 21 can be applied in the fabrication of a capacitive pressure sensor on top of the passivation layer of an IC (ASIC and MEMS in one sensor die 11).

Figure 7B shows a further example of the sensor arrangement 10 that is a further development of the examples shown above. In Figure 7B, three dies of the sensor arrangement 10 are shown before separation. The sensor die 11 is realized on a CMOS wafer. The sensor die 11 is a part of a CMOS wafer. The wafer comprising the three sensor dies 11 is hold to a chuck 110 by an under-pressure between the wafer comprising the sensor dies 11 and the chuck 110.

The advantage of this manufacturing approach is that no individual die placement is required (cost reduction) and that the diving board 11 is only created during dicing and singulation of the wafer stack 112. Advantageously, the devices can be tested and even calibrated at wafer level which gives additional benefits from test cost perspective. This allows to probe the wafer by the electrical contacts on the bottom side 47 of the interposer 12. The wafer can be vacuum chucked without impacting the pressure reading. The access to the pressure sensitive membranes 20, 21 is from the side of the wafer (see Figure 7B). Wafer level test is feasible from interposer side after WTW bonding. Probing on interposer balls 40, 41 is shown but also probing on test pads is possible. Air access is from the side of the wafer. Vacuum chucking of the wafer is on the CMOS side and does not interfere with ambient pressure reading.

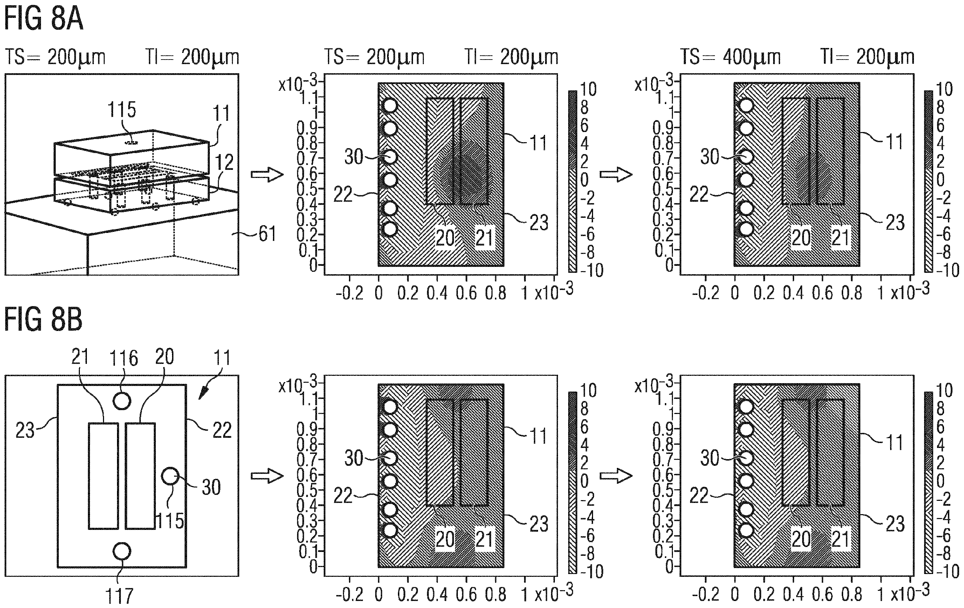

Figure 8A shows examples of characteristics of the sensor arrangement 10 which may be realized as one of the above-shown embodiments. The sensor die 11 is realized as a CMOS die. A single force realized as a single point force is applied to the center of the sensor die 11. The left side of Figure 8A shows the configuration of the sensor arrangement 10. The characteristic shown in the middle of Figure 8A is determined for the thickness TS of the sensor die 11 and the thickness TI of the interposer 12 being equal and having a value of 200 µm. The characteristic shown in the right side of Figure 8A is simulated for the thickness TS of the sensor die 11 of 400 µm and the thickness TI of the interposer 12 of 100 µm. As can be seen in Figure 8A, a stress in the membrane 20 and the further membrane 21 is lower in the case of a higher thickness of the sensor die 11 and a lower thickness of the interposer 12. The stress can be reduced by a thickness optimization of the thickness TS of the sensor die 11 to the thickness TI of the interposer 12. The sensor die 11 may comprise a contact point 115 that is located at the second side 19 of the sensor die 11. The contact point 115 is realized as an extension or elevation above the area of the second side 19 of the sensor die 11. The contact point 115 may have a thickness larger than 5 µm or 20 µm or 100 µm.

In Figure 8B, the stress is simulated for a force having 1 Newton divided over three contact points 115 to 117 as indicated in the sensor arrangement 10 shown on the left side of Figure 8B. The thickness TS of the sensor die 11 and the thickness TI of the interposer 12 in the middle and in the right side of Figure 8B have the values such as indicated in Figure 8A. The stress is equal and nearly independent from the selection of the thickness TS of the sensor die 11 and of the thickness TI of the interposer 12. In the right of Figure 8B, the membranes 20, 21 are located to the outside of the diving board. The sensor die 11 may comprise at least one contact point 115 to 117 that is located at the second side 19 of the sensor die 11. For example, the sensor die 11 may comprise three contact points 115 to 117 that are located at the second side 19 of the sensor die 11. At least one of the contact points 115 to 117 is located above the contact area 14. At least one of the contact points 115 to 117 is located above the suspended area 15. Each of the contact points 115 to 117 may be located outside of the area of the membrane 20 or the membranes 20, 21.

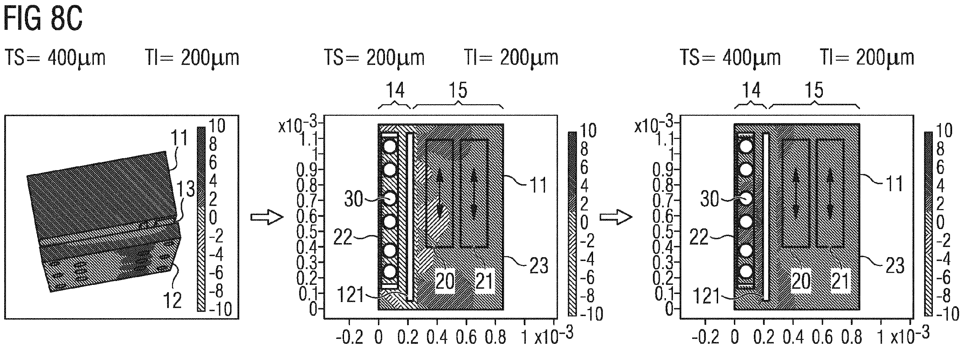

As shown in Figure 8C, the support 13 comprises a bar 121 that is between the first number N of contact joints 30 to 35 and the suspended area 15. The bar 121 may be named as support bar, supporting bar or separation bar. Thus, the bar 121 forms an edge of the contact area 14. The bar 121 is fabricated by the same steps as the first number N of contact joints 30 to 35. The bar 121 has a similar function as the guard ring 37 with respect to the stress. The bar 121 is rectangular in a top view. The bar is between the first number N of contact joints 30 to 35 and the membrane 20 (or the membranes 20, 21). The bar 121 is parallel to the imaginary line 36 through the first number N of contact joints 30 to 35. Stress is lower for the configuration with the higher thickness TS of the sensor die 11 and the lower thickness TI of interposer 12. As can be seen from a comparison of Figures 8A, 8B and 8C, the bar 121 results in a stress reduction. In Figure 8C, the supporting bar 121, a relocation of the vias and a rearrangement of bottom contact pads are provided.

In Figures 8A to 8C, the impact of contact points 115 to 117 and location on stress in x-direction of the sensor die 11 is elucidated. The thickness TS of the sensor die 11, membrane location with respect to the diving board support 13 and the contact points 115 to 117 and the interposer bond pads 40 to 45 which may be solder joints between the interposer 12 to the PCB 61 are important to reduce stress. The use of three contact points 115 to 117 on the diving board 11 transfers the mechanical loads to location outside the area of the membrane 20 or the membranes 20, 21. The bar 121 directed in the longitudinal direction of the rectangular membrane 20 helps to reduce localized stress field around the solder pads 30 to 35.

The bar 121 is arranged in the direction of the rectangular membranes 20, 21. If configured as guard ring 37 around the bond pads 30 to 35, the bond pads 30 to 35 can be shielded and protected from contact with water. The use of eutectic bonding in this respect allows to construct the guard ring 37 as well as the bond pads 30 to 35 between the sensor die 11 to the interposer 12 in one step. The bar 121 constructed as guard ring 37 also serves to reduce the overhang of the diving board 11 and ensure a uniform stress distribution. This is advantageous during the calibration step where the CSP package will be probed via the interposer balls or interposer bond pads 40 to 45 on the bottom 47 of the interposer 12. The CSP will be pushed against a metal support thereby deforming the diving board 11 depending on which contact point 115 to 117 the CSP will be pushing.

In Figures 8A to 8C, several device configurations are drawn and modelled to show the impact of mechanical stress during calibration. In Figure 8A, the stress is modelled in x-direction at membrane level in the diving board 11 for the interposer 12 having a thickness TI of 200 µm and the diving board 11 having a thickness TS of 200 µm when pushing with a 1 N force in the center of the CSP package. As becomes apparent from the graph the stress is highest in the center of the sensor die 11 underneath the contact point 115. If the thickness TS of the diving board 11 is increased to 400 µm and the interposer 12 is reduced to 100 µm to keep the overall package height below 600 µm, the stress field around the contact point 115 is significantly reduced.

In order to reduce the stress in x direction at the membranes 20, 21 it is proposed to have at least three contact points 115 to 117 on the top of the CSP package that are located outside the membrane area, as shown in Figure 8B. In addition, it is advantageous to place the membranes 20, 21 as far as possible to the edge 23 of the diving board 11 as the stress reduces towards the free hanging part 15 of the diving board 11 as shown in Figure 8B on the most right image.

The use of the bar 121 placed next to the electrical joints 30 to 35 helps to create a uniform stress field and also reduces bending of the diving board 11, as shown in Figure 8C on the left. The location of the bottom contact joints 30 to 35 with respect to the contact points 115 to 117 on the top side 19 may direct the forces through without deformation of the diving board 11.

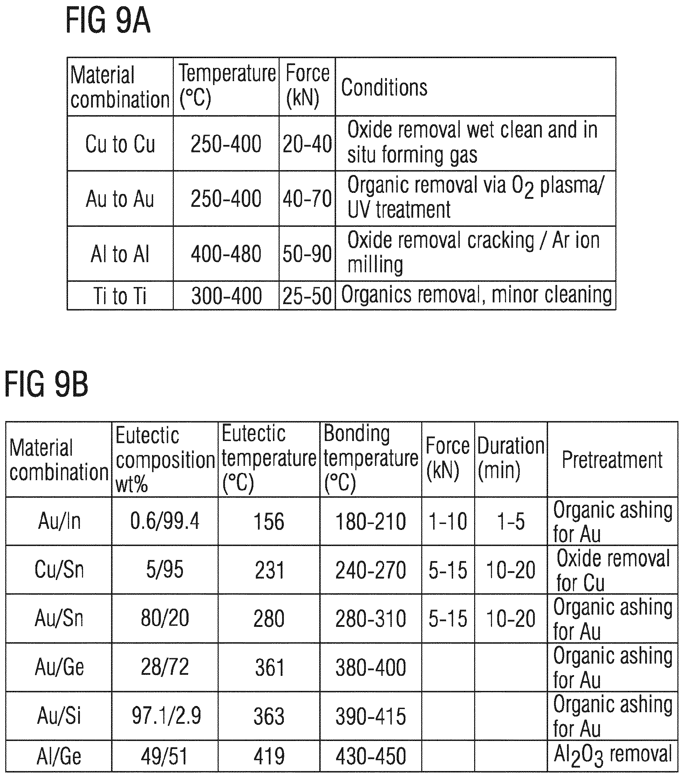

Figure 9A shows a table for materials which can be used for WTW bonding of the sensor die 11 to the interposer 12. The WTW bonding can be fabricated by a metal diffusion technique. The material of the bond pad 50 on the first side 18 of the sensor die 11 and the material of the further bond pad 51 on the first side 46 of the interposer 12 may be e.g. both copper, both gold, both aluminum or both titanium. Thus, the support 13 with the contact joints 30 to 35 consists of one metal of the group consisting of copper, gold, aluminum and titanium. There might by slight additions to a metal, for example Si and/or Cu may be added to Al to improve the performance of Al. In the table also the temperature range for the metal diffusion bonding technique, the force which has to be applied to the two wafers and further conditions are listed.

In Figure 9A, the WTW bonding using a metal diffusion bonding techniques is described. Details are shown in the table in Figure 9A. For metal diffusion bonding, a smooth and clean metal surface and an intimate contact of the bonding layers is advantageous. The bonding principle is based on solid phase inter diffusion. A high uniform force is used. Clean interfaces (oxide free) allow for good bonding properties. Typical bonding temperatures are e.g. 300-480 °C.

Figure 9B shows the materials and further information for WTW bonding realized as metal eutectic alloy bonding. The support 13 may be e.g. fabricated using one of the following material combinations which are alloys: gold indium (AuIn), cupper tin (CuSn), gold tin (AuSn), gold germanium (AuGe), gold silicon (AuSi) and aluminum germanium (AlGe). More exactly, the alloys are AuₓIn_{y}, CuₓSn_{y}, AuₓSn_{y}, AuₓGe_{y}, AuₓSi_{y} and/or AlₓGe_{y}. Thus, the bond pad 50 of the sensor die 11 may include a gold layer and the further bond pad 51 of the interposer 12 may include an indium layer or vice versa. Thus, a gold/indium layer stack is used for eutectic bonding. The symbol / indicates a layer stack. After the eutectic bonding process, the support 13 with the contact joints 30 to 35 includes a eutectic alloy of a group consisting of gold-indium eutectic alloy (AuIn), cupper-tin eutectic alloy (CuSn), gold-tin eutectic alloy (AuSn), gold-germanium eutectic alloy (AuGe), gold-silicon eutectic alloy (AuSi) and aluminum-germanium eutectic alloy (AlGe). After eutectic bonding, the support 13 comprises the eutectic alloy (for example the eutectic alloy Au-In) and possibly a residual metal layer (e.g. Au or In) which has not been become liquid during the heating process.

Thus, the material of the bond pad 50, of the further bond pad 51 and of the metal between the bond pad 50 and the further bond pad 51 can be, for example, selected out of one of the above-listed material combinations. In the table shown in Figure 9B also the composition for the realization of the eutectic compound in percentage of weight, the eutectic temperature, the typical bonding temperature which is higher than the eutectic temperature, the applied force, the duration of the process and information about the pretreatment are listed.

Metal eutectic alloy bonding allows to reduce the bonding temperature in some cases but may require good protection against oxidation. During heating 20°C to 30°C above the eutectic temperature the two metals will melt and diffuse into each other forming intermetallic bond. A homogeneous temperature (+/-2°C) and pressure is applied.

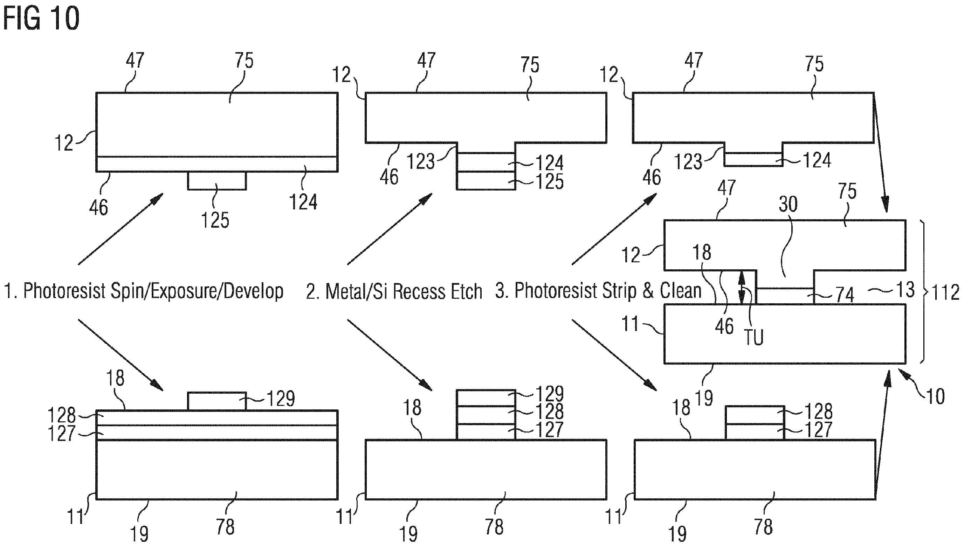

Figure 10 shows an example of a fabrication process of the sensor arrangement 10 realized such as one of the examples described above.

In the top the process performed at the wafer comprising the interposer 12 is illustrated. On the first side 46 of the interposer 12 a first metal layer 124 such as for example a germanium layer is deposited on the interposer substrate 75. A photoresist 125 is arranged on the first metal layer 124. The photoresist 125 is fabricated by a photoresist spin-on process, an exposure process and a development process. As shown in the middle the first metal layer 124 is etched at those areas that are not covered by the photoresist 125. The etching is performed such that not only the uncovered areas of the first metal layer 124 but also some material of the interposer substrate 75 are removed. Thus, a recess 123 in the interposer substrate 75 is formed. The interposer substrate 75 may be a semiconductor substrate, a ceramic substrate, a glass substrate or a polymer substrate. The semiconductor substrate may be e.g. a silicon substrate. As shown in the upper line on the right side, the photoresist 125 is removed. The first metal layer 124 is located on a raised part of the interposer substrate 75.

On the bottom of Figure 10, fabrication steps of the sensor die 11 are shown. The sensor die 11 comprises the sensor substrate 78 and a first metallization layer 127 which may be, for example, aluminum. The sensor die 11 comprises a second metallization layer 128 which may be, for example germanium. The first metallization layer 127 is deposited on the sensor substrate 78 or on top of the not-shown metallization stack 79 of the sensor die 11. The second metallization layer 128 is deposited on the first metallization layer 127. For patterning the first and the second metallization layer 127, 128 a further photoresist 129 is realized by a photoresist spin-on process, an exposure process and a development process. As shown in the middle, the further photoresist 129 is used as a mask for etching the second and the first metallization layer 127, 128. Shown in the right side in the lower line of Figure 10, the further photoresist 129 is removed by a strip process. Thus, a stack of the first and the second metallization layer 127, 128 is realized.

As shown on the right side in the middle of Figure 10, the wafer comprising the sensor die 11 and the wafer comprising the interposer 12 are attached to each other and form the wafer stack 112. The wafer stack 112 is heated up to the bonding temperature and a force is applied to the wafer stack 112. Thus, the first metal layer 124 realizes together with the first and the second metallization layer 127, 128 the eutectic bonding material 74. The eutectic bonding material 74 is an alloy after the eutectic bonding process. The distance between the sensor die 11 and the interposer 12 mainly depends on the thickness of the eutectic bonding material 74 and of the recess 123 in the interposer 12. The distance is approximately the thickness TU of the support 13 (in case the raised part of the interposer 12 is considered as part of the support 13).

Typically the metal deposition may be thicker than the actual "protruding height" of the membranes out of the surface. Optionally, the Al and or the AL/Ge can be deposited and patterned on areas of the chip that stick out from the surface.

In an alternative embodiment, not shown, the step of realizing the recess 123 is omitted. The etching step stops at the material of the interposer substrate 75. Eutectic bonding can be performed without the recess 123.

In an alternative embodiment, not shown, the sensor die 11 and of the interposer 12 are interchanged in Figure 10. Thus, the upper line shows the fabrication steps for the sensor die 11 and the lower line of Figure 10 shows the fabrication steps for the interposer 11. The first metal layer 124, e.g. Ge, can be deposited on the sensor die 11 and the first and the second metallization layer, e.g. Al/Ge, can be deposited on the interposer 12.

In Figure 10, eutectic bonding process steps using metal layers Al/Ge resulting in the alloy AlGe are illustrated. The advantage of Al/Ge eutectic bonding are the low cost and CMOS compatible fab friendly materials (see Figure 9B). Al/Ge offers a higher hermeticity than other metal combinations for a certain metal width. Bonding temperature is <450C which is a good fit for MEMS processing on a CMOS circuit without degradation of metal interconnects.

The embodiments shown in the Figures 1 to 10 as stated represent example embodiments of the improved sensor arrangement; therefore, they do not constitute a complete list of all embodiments according to the improved sensor arrangement. Actual sensor arrangement configurations may vary from the embodiments shown in terms of circuit parts, structures, shape, size and materials, for example.

### Reference Numerals

- 10: sensor arrangement
- 11: sensor die
- 12: interposer
- 13: support
- 14: contact area
- 15: suspended area
- 16: sensitive element
- 17: further sensitive element
- 18: first side
- 19: second side
- 20: membrane
- 21: further membrane
- 22: first edge
- 23: second edge
- 30 to 35: contact joint
- 36: imaginary line
- 37: guard ring
- 38, 39: main membrane direction
- 40 to 45: interposer bond pad
- 46: first side
- 47: second side
- 48, 49: via
- 50: bond pad
- 51: further bond pad
- 52: solder joint
- 53: metal plug
- 54: isolating layer
- 55 to 58: conducting line
- 60: arrangement
- 61: printed circuit board
- 62: first side
- 63: second side
- 64, 65, 67 to 69: conducting line
- 66: underfill
- 70: electrically isolating spacer
- 71: mechanical tool
- 72, 73: pin
- 74: eutectic bonding material
- 75: interposer substrate
- 76: interposer metallization stack
- 77: first metallization layer
- 78: sensor substrate
- 79: metallization stack
- 81: top electrode
- 82: bottom electrode
- 84, 86, 91: dielectric layer
- 85: cavity
- 92: first metallization layer
- 93, 94, 97: via
- 95: metal layer
- 96, 98, 99, 100: part
- 101, 102: dielectric layer
- 103, 106: conducting via layer
- 104: isolating via layer
- 105: opening
- 110: chuck
- 112: wafer stack
- 115 to 117: contact point
- 121: bar
- 123: recess
- 124: first metal layer
- 125, 129: photoresist
- 127, 128: metallization layer

## Claims

1. Sensor arrangement, comprising
- a sensor die (11), comprising a contact area (14), a suspended area (15) and a sensitive element (16) located in the suspended area (15),
- an interposer (12), comprising at least two vias (48, 49) connecting a first side (46) of the interposer (12) to a second side (47) of the interposer (12), and
- a support (13) which mechanically and electrically connects the contact area (14) of the sensor die (11) to the first side (46) of the interposer (12) and comprises at least two contact joints (30 to 35).

2. Sensor arrangement of claim 1,
wherein the support (13) comprises a bar (121) oriented parallel to an imaginary line (36) through the at least two contact joints (30 to 35) and connects the contact area (14) of the sensor die (11) to the first side (46) of the interposer (12).

3. Sensor arrangement of claim 1,
wherein the support (13) comprises a guard ring (37) that surrounds the at least two contact joints (30 to 35) and connects the contact area (14) of the sensor die (11) to the first side (46) of the interposer (12).

4. Sensor arrangement of one of claims 1 to 3,
wherein the sensitive element (16) comprises a membrane (20) which is rectangular and has a main membrane direction (38), and
wherein the main membrane direction (38) is parallel to an imaginary line (36) through the at least two contact joints (30 to 35).

5. Sensor arrangement of claim 4,
wherein the sensor die (11) comprises a first and a second edge (22, 23) which are parallel to each other,
wherein the first edge (23) is adjacent to the contact area (14), and
wherein the second edge (24) is adjacent to the suspended area (15) and is parallel to the main membrane direction (38) .

6. Sensor arrangement of claim 4 or 5,
wherein the sensor die (11) comprises a further sensitive element (17) located in the suspended area (15) and comprising a further membrane (21), and
wherein the further membrane (21) is rectangular and a main membrane direction (39) of the further membrane (21) is parallel to the main membrane direction (38) of the membrane (20) .

7. Sensor arrangement of one of claims 1 to 6,
wherein at least one of the sensor die (11) and the interposer (12) comprises a CMOS integrated circuit,
in particular wherein the sensor die (11) comprises the CMOS integrated circuit and the CMOS integrated circuit is connected to the sensitive element (16).

8. Sensor arrangement of one of claims 1 to 7,
wherein the interposer (12) is realized as one of a group comprising an interconnecting carrier, an interconnecting board and an interconnecting substrate.

9. Sensor arrangement of one of claims 1 to 8,
wherein the at least two contact joints (30 to 35) comprise a material out of a group comprising Cu, Au, Al and Ti or a material combination out of a group comprising AuIn, CuSn, AuSn, AuGe, AuSi and AlGe.

10. Sensor arrangement of one of claims 1 to 9,
wherein the sensitive element (16) is one of a group comprising a pressure sensor element, an accelerometer element, a gyroscope element, an ultrasound transducer, a microphone, a speaker, a micro hot plate, an IR radiation detector and a bolometer.

11. Sensor arrangement of one of claims 1 to 10,
wherein the interposer (12) comprises at least two interposer bond pads (40 to 45) and/or conducting lines (57, 58) on the second side (47) of the interposer (12), and
wherein the at least two interposer bond pads (40 to 45) and/or conducting lines (57, 58) are coupled to the at least two vias (48, 49) of the interposer (12) and are operable to contact a printed circuit board (61).

12. Sensor arrangement of one of claims 1 to 11,
wherein the sensor arrangement (10) comprises an electrically isolating spacer (70) arranged between the first side (46) of the interposer (12) and the first side (18) of the sensor die (11) .

13. Apparatus,
comprising the sensor arrangement (10) of one of claims 1 to 12, wherein the apparatus is realized as one of a mobile device, a wearable, a vehicle and an air conditioner.

14. Method for fabricating a sensor arrangement, comprising
- providing a sensor die (11) that comprises a contact area (14), a suspended area (15) and a sensitive element (16) located in the suspended area (15),
- providing an interposer (12) that at least two vias (48, 49) connecting a first side (46) of the interposer (12) to a second side (47) of the interposer (12), and
- connecting the sensor die (11) to the interposer (12) by a support (13) which mechanically and electrically connects the contact area (14) of the sensor die (11) to the first side (46) of the interposer (12) and comprises at least two contact joints (30 to 35).

15. Method of claim 14,
wherein the support (13) is fabricated by wafer diffusion bonding or eutectic bonding.
